# EUROPÄISCHE PATENTSCHRIFT

(11) **EP 0 763 843 B1**
(45) Veröffentlichungstag und Bekanntmachung des Hinweises auf die Patenterteilung: **13.10.1999**
(21) Anmeldenummer: 96112318.9
(22) Anmeldetag: 30.07.1996
(51) Int. Cl.: H01H 50/04

(54) **Elektrisches Bauelement, insbesondere relais, und Verfahren zu dessen Einbau in eine Leiterplatte**
Electrical element, preferably relay, and method for mounting the same on a printed circuit board
Elément électrique, notamment relais, et procédé de son montage sur circuit imprimé

(30) Priorität: 28.08.1995 DE 19531634
(43) Veröffentlichungstag der Anmeldung: 19.03.1997
(73) Patentinhaber: SIEMENS AKTIENGESELLSCHAFT, 80333 München (DE)
(72) Erfinder: Hoffmann, Ralf, 12349 Berlin (DE)

(56) Entgegenhaltungen:
- EP-A- 0 177 798
- DE-A- 3 641 427
- DE-A- 3 835 105

## Beschreibung

Die Erfindung betrifft ein elektrisches Bauelement, insbesondere ein elektromagnetisches Relais, mit einem annähernd quaderförmigen Gehäuse, welches eine Anschlußseite aufweist, aus der Anschlußfahnen in einer einzigen geraden Reihe nebeneinander austreten, wobei die Anschlußfahnen nach einer Leiterplattenseite des Bauelementes hin gewandte, in einer gemeinsamen Ebene liegende flache Lötanschlußflächen bilden. Außerdem betrifft die Erfindung ein Verfahren zum Einbau eines solchen Bauelementes in eine Leiterplatte.

Elektromechanische Bauelemente mit mehr als zwei Anschlüssen, wie beispielsweise Relais, haben in der Regel Anschlußfahnen, die über die Bodenseite des Gehäuses in unterschiedlicher Weise verteilt sind. Neuerdings besteht jedoch in bestimmten Fällen der Wunsch, daß diese Bauelemente alle Anschlüsse in einer Reihe aufweisen, damit sie zusammen mit zweipoligen Bauelementen möglichst raumsparend in einer Schaltbox eines Fahrzeuges oder in der Steuerung einer mit Netzstrom betriebenen Anlage untergebracht werden können. Der Anschluß kann dabei über eine Steckfassung oder durch Einlöten auf einer Leiterplatte erfolgen. Dabei ist es dann auch erwünscht, daß das Gehäuse entsprechend zu der einen Reihe von Anschlußfahnen auch einen möglichst schmalen Aufbau hat. Ein derartiges Relais ist beispielsweise in der DE 38 35 105 C2 gezeigt, wobei das quaderförmige Gehäuse sehr unterschiedliche Seitenlängen aufweist, also eine im Vergleich zur Länge und Höhe sehr geringe Breite.

Um solche Relais mit schmalem Gehäuse möglichst vielseitig einsetzen zu können, ist man bestrebt, sie so zu gestalten, daß sie mit dem gleichbleibenden inneren Aufbau und mit nur geringfügigen Änderungen an der Außenseite auch für die Oberflächen-Montagetechnik (SMT) einsetzbar sind, wobei in diesem Fall ein um 90° gedrehter Einbau bevorzugt wird, also die kürzeste Seite die Bauhöhe über der Leiterplatte bestimmt und die Anschlußfahnen nicht an der Leiterplatten-Einbauseite, sondern an einer Längsseite austreten, wo sie für das Reflow-Löten leichter zugänglich sind. Dies kann beispielsweise dadurch geschehen, daß die Anschlußfahnen von ihrer gemeinsamen Austrittsebene nach unten zur Leiterplatte hin abgekröpft und mit den abgekröpften Enden auf der Leiterplatte verlötet werden. Durch diese einseitige Anbindung des relativ schweren Relais ist dieses jedoch anfällig für Stöße und Erschütterungen, wobei die auftretenden Kräfte über die Anschlußfahnen auch in das Relaisinnere einwirken und dort beispielsweise die Kontaktjustierung verändern können.

Ziel der vorliegenden Erfindung ist es, ein elektrisches Bauelement der eingangs angegebenen Art mit einem quaderförmigen Gehäuse unterschiedlicher Seitenlängen für einen flachen Einbau auf einer Leiterplatte so zu gestalten, daß eine sichere Positionierung beim Einlöten und eine stabile Befestigung im Betrieb erzielt wird, wobei eine möglichst geringe Bauhöhe über der Leiterplatte angestrebt wird.

Erfindungsgemäß wird dieses Ziel dadurch erreicht, daß das Gehäuse an mindestens einer weiteren Seite mindestens ein vorstehendes Stützelement aufweist, das eine in der Ebene der Lötanschlußflächen liegende Abstützfläche bildet.

Durch die erfindungsgemäß vorgesehenen Stützelemente an einer oder mehreren Seitenwänden des Gehäuses, die den Anschlußfahnen gegenüberliegende Abstützflächen gleicher Höhe bilden, erhält das Bauelement bzw. das Relais eine statisch bestimmte Position auf der Leiterplatte, die bereits beim Einlöten von Vorteil ist, aber auch im Betrieb eine Sicherung gegen Erschütterungen und gegen das Auftreten von Biegekräften an den Anschlußfahnen bietet.

Die Stützelemente können verschiedene Formen haben und an verschiedenen Umfangsseiten des Gehäuses angebracht sein. Sie können beispielsweise als angespritzte Kunststoffarme aus dem Material einer Gehäusekappe geformt oder auch als Metallstreifen bzw. als Drähte (als sogenannte Blind-Pins) in die Gehäusekappe eingebettet sein. Sie können eine Vorfixierung des Relais zum Löten bieten, etwa in Form von Haltezapfen, die in Löcher der Leiterplatte eingedrückt werden, oder auch dadurch, daß sie vor dem Löten auf die Leiterplatte geklebt werden.

Eine besonders vorteilhafte Ausführungsform erzielt man in der Anwendung mit einer Leiterplatte, die eine Aussparung entsprechend der Umfangskontur des Bauelement-Gehäuses aufweist. In diesem Fall wird das Relaisgehäuse in die Aussparung der Leiterplatte gesenkt, wobei die Anschlußfahnen auf der einen Seite und die Stützelemente auf der anderen Seite neben der Aussparung auf der Leiterplatte aufliegen. In diesem Fall erreicht man eine besonders geringe Bauhöhe und auch vereinfachte Arbeitsgänge bei der Herstellung und bei der Montage, da die Anschlußelemente lediglich geradlinig aus dem Gehäuse herausgeführt und in dieser geraden Form auf der Leiterplatte aufliegend verlötet werden können.

Die Erfindung wird nachfolgend an Ausführungsbeispielen anhand der Zeichnung näher erläutert. Es zeigt
Figur 1 ein erfindungsgemäß gestaltetes Relais in perspektivischer Ansicht über einer mit einer Aussparung versehenen Leiterplatte,
Figur 2 das Relais und die Leiterplatte von Figur 1 nach der Montage in einer etwas gedrehten perspektivischen Ansicht,
Figur 3 bis 5 verschiedene Abwandlungen des Relaisgehäuses mit unterschiedlichen Anschlußfahnen für die SMT-Montage.

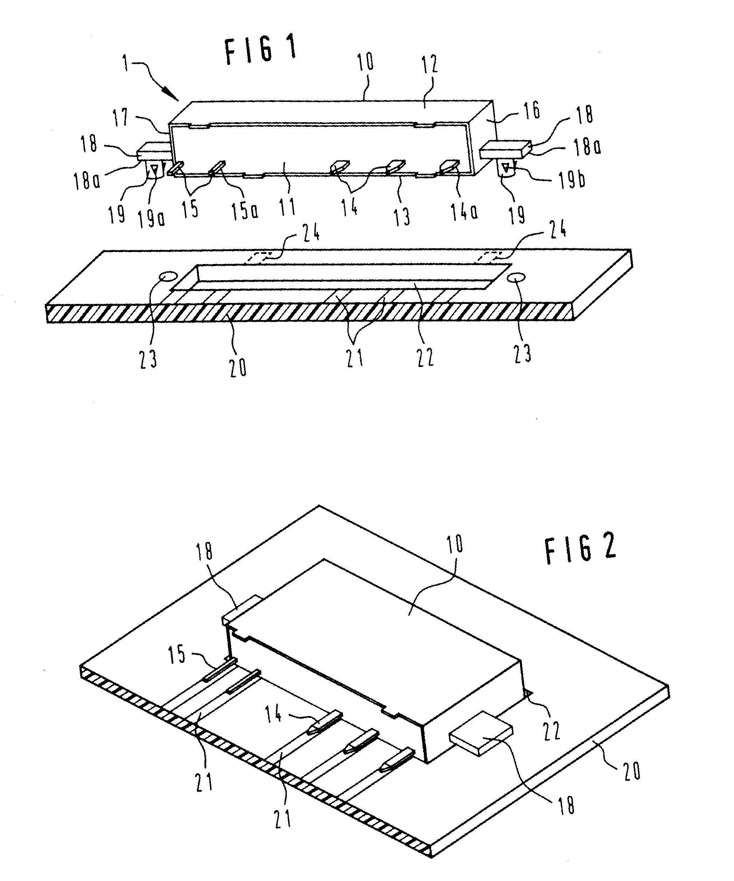

In Figur 1 ist ein Relais 1 mit einem Gehäuse 10 über einer Leiterplatte 20 dargestellt. Das Gehäuse besteht aus einem Sockel, der eine Anschlußseite 11 bildet, und einer Kappe 12. Der Sockel hat stark unterschiedliche Seitenlängen, so daß das Relais bei üblicher Einbaulage (auf der Anschlußseite 11 stehend) eine im Vergleich zur Länge und Höhe geringe Breite aufweist. Im vorliegenden Fall gemäß Figur 1 und 2 ist jedoch das Gehäuse 10 um 90° zur Seite gedreht angeordnet, so daß die Anschlußseite 11 eine der Seitenwände bildet und die nach unten gekehrte Seitenwand der Kappe 12 als Leiterplattenseite 13 der Leiterplatte 20 zugekehrt ist. Die Kontakt-Anschlußfahnen 14 und die Spulen-Anschlußfahnen 15, die senkrecht aus der Anschlußseite 11 austreten, liegen nunmehr parallel zur Oberfläche der Leiterplatte 20. An ihren der Leiterplatte zugewandten Unterseiten bilden die Anschlußelemente 14 und 15 jeweils Lötanschlußflächen 14a bzw. 15a für eine SMT-Montage. Außerdem sind an den zur Anschlußseite 11 benachbarten Seitenwänden 16 und 17 einander gegenüberliegend Haltearme 18 angeformt, die an ihrer Unterseite jeweils eine Abstützfläche 18a bilden. Außerdem besitzen die Haltearme 18 im vorliegenden Beispiel senkrecht nach unten abstehende Haltezapfen 19, die mit andeutungsweise gezeigten Rastmitteln, beispielsweise einem verbreiterten Randwulst 19a oder Quetschrippen 19b, versehen sein können.

Die Leiterplatte 20 ist mit den üblichen Leiterbahnen 21 versehen und besitzt im gezeigten Beispiel eine rechteckige Aussparung 22 entsprechend der Umfangskontur des Bauelementgehäuses 10. Neben der Aussparung 22 sind noch Bohrungen 23 zur Aufnahme der Haltezapfen 19 vorgesehen.

Bei der Montage des Relais 1 wird das Gehäuse 10 in die Aussparung 22 teilweise eingesenkt, wie dies in Figur 2 gezeigt ist. Dabei kommen die Anschlußfahnen 14 und 15 auf den Leiterbahnen 21 zu liegen, während die Haltearme 18 jeweils seitlich auf der Leiterplattenoberfläche aufliegen. Die Haltezapfen 19 sind in die Bohrungen 23 eingesteckt und ergeben mit diesen je nach den Abmessungen und Gestaltungen verschiedener Rast- oder Klemmittel eine formschlüssige bzw. eine kraftschlüssige Verbindung durch Verrastung und/oder Klemmung. Unabhängig von den Haltezapfen 19 könnten die Haltearme 18 auch auf die Leiterplatte geklebt werden. In jedem Fall wird das Bauelement 1 durch die Haltearme 18 auf der Leiterplatte 20 für die spätere Lötung stabil positioniert und vorzugsweise vorfixiert. Somit können die Anschlußfahnen 14 und 15 in üblicher Weise durch Reflow-Löten auf der Leiterplatte kontaktiert werden. Auch im Betrieb ergeben dann die Haltearme 18 zusammen mit den verlöteten Anschlußfahnen eine stabile und statisch bestimmte Fixierung des Bauelementes.

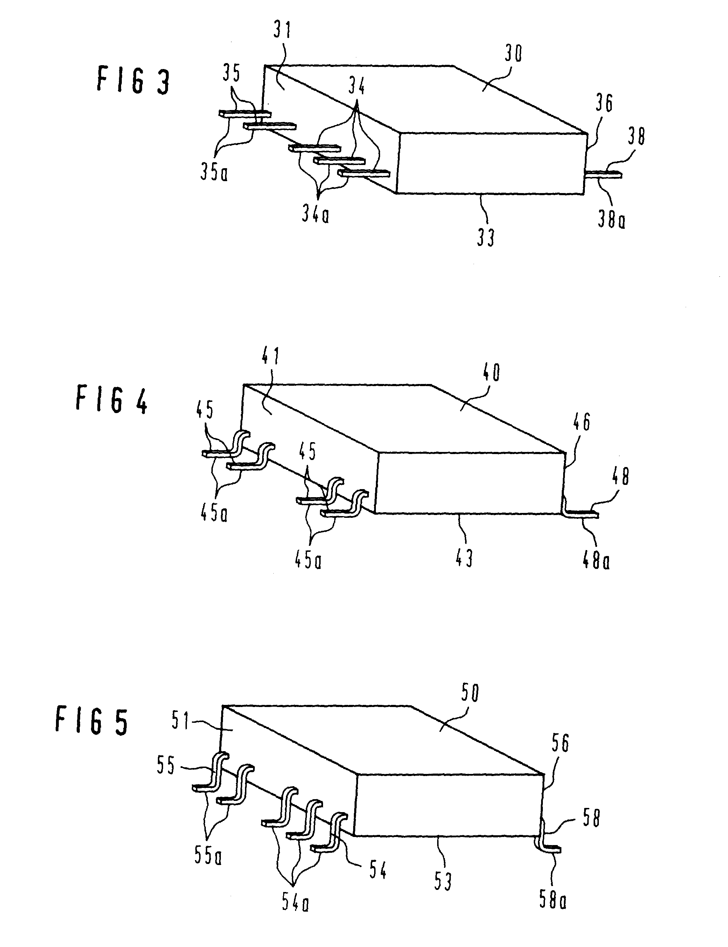

In den Figuren 3 bis 5 sind noch einige Abwandlungen des Bauelementgehäuses dargestellt. So zeigt Figur 3 ein quaderförmiges Gehäuse 30 mit aus einer Anschlußseite 31 austretenden Anschlußfahnen 34 und 35. Dieses Bauelement kann wie die Ausführungsform von Figur 1 in eine Aussparung 22 einer Leiterplatte eingesetzt werden. Als Stützelemente sind nunmehr aber statt der einander gegenüberliegenden Haltearme 18 metallische Stützfahnen 38 den Anschlußfahnen 34 bzw. 35 gegenüberliegend angeordnet, vorzugsweise in das Gehäusematerial eingebettet. Diese Stützfahnen 38 können mit Abstützflächen 38a beispielsweise auf metallisierte Auflagepunkte 24 (siehe Figur 1) der Leiterplatte 20 aufgelegt und mit diesen verlötet werden. Dies kann gleichzeitig mit dem Reflow-Löten der Anschlußfahnen 34 und 35 an deren Lötanschlußflächen 34a und 35a erfolgen.

Eine abgewandelte Ausführungsform ist in Figur 4 gezeigt. Von einem Bauelementgehäuse 40 treten an einer Anschlußseite 41 Anschlußfahnen 44 und 45 aus, die zu einer Leiterplattenseite 43 hin abgekröpft sind, so daß an ihrer Unterseite gebildete Lötanschlußflächen 44a bzw. 45a annähernd in der Ebene der Leiterplattenseite 43 liegen. Das Bauelement kann also auf einer Leiterplatte aufgelegt und in üblicher Weise auf deren Oberfläche verlötet werden. Auch dieses Gehäuse besitzt zusätzliche, den Anschlußfahnen 44 und 45 gegenüberliegende Abstützfahnen 48, die in gleicher Weise wie die Anschlußfahnen abgekröpft sind und auf der Leiterplattenoberfläche verlötet werden können.

Ein in Figur 5 gezeigtes weiteres Ausführungsbeispiel mit einem Gehäuse 50 besitzt ebenfalls abgekröpfte Anschlußfahnen 54 und 55, die aus einer Anschlußseite 51 austreten. An der der Anschlußseite gegenüberliegenden Seite sind Stützfahnen 58 verankert und wie die Anschlußfahnen abgekröpft. Diese Abkröpfung ist in diesem Fall jedoch so groß gewählt, daß die Lötanschlußflächen 54a und 55a sowie die Abstützflächen 58a um eine bestimmte Höhe gegenüber der Leiterplattenseite 53 nach unten versetzt angeordnet sind. Bei der Montage auf einer Leiterplatte entsteht also unter dem Bauelementgehäuse 50 ein freier Raum, in welchem weitere kleine Bauelemente untergebracht werden können.

Für alle Beispiele gilt im übrigen, daß anstelle der flachen Anschlußfahnen bzw. Stützfahnen jeweils aus Runddraht gebildete Anschluß- bzw. Stützelemente verwendet werden können, die dann entsprechend mit ihrem unten liegenden Umfangsbereich aufliegen und verlötet werden.

## Patentansprüche

1. Elektrisches Bauelement, insbesondere Relais, mit einem annähernd quaderförmigen Gehäuse (10; 30; 40; 50), welches eine Anschlußseite (11; 31; 41; 51) aufweist, aus der Anschlußfahnen (14, 15; 34, 35; 44, 45; 54, 55) in einer einzigen geraden Reihe nebeneinander austreten, wobei die Anschlußfahnen nach einer Leiterplattenseite (13; 33; 43; 53) des Bauelementes gewandte, in einer gemeinsamen Ebene liegende, flache Lötanschlußflächen (14a, 15a; 34a, 35a; 44a, 45a; 54a, 55a) bilden, **dadurch gekennzeichnet,** daß das Gehäuse (10; 30; 40; 50) an mindestens einer weiteren Seite (16, 17; 36; 46; 56) mindestens ein vorstehendes Stützelement (18; 38; 48; 58) aufweist, das eine in der Ebene der Lötanschlußflächen liegende Abstützfläche (18a; 38a; 48a; 58a) bildet.

2. Bauelement nach Anspruch 1, **dadurch gekennzeichnet,** daß Stützelemente in Form vorspringender Arme (18) an zwei an die Anschlußseite (11) angrenzenden, einander gegenüberliegenden Seiten (16, 17) des Gehäuses (10) vorgesehen sind.

3. Bauelement nach Anspruch 1 oder 2, **dadurch gekennzeichnet,** daß Stützelemente (38; 48; 58) an der der Anschlußseite (31; 41; 51) gegenüberliegenden Gehäuseseite (36; 46; 56) vorgesehen sind.

4. Bauelement nach einem der Ansprüche 1 bis 3, **dadurch gekennzeichnet,** daß die Stützelemente (18) senkrecht zur Ebene der Abstützflächen gerichtete Haltezapfen (19) aufweisen.

5. Bauelement nach Anspruch 4, **dadurch gekennzeichnet,** daß die Haltezapfen (19) mit Rast- oder Klemmelementen (19a, 19b) versehen sind.

6. Bauelement nach einem der Ansprüche 1 bis 5, **dadurch gekennzeichnet,** daß die Stützelemente (38; 48; 58) aus Metall bestehen und in Form von Blechstreifen oder Drähten in dem Gehäuse verankert sind.

7. Bauelement nach einem der Ansprüche 1 bis 5, **dadurch gekennzeichnet,** daß die Stützelemente (18) einstückig mit einem Teil des Gehäuses aus Kunststoff geformt sind.

8. Bauelement nach einem der Ansprüche 1 bis 7, **dadurch gekennzeichnet,** daß die Anschlußfahnen (44, 45) parallel zueinander in Richtung auf die Leiterplattenseite (43) gekröpft sind und annähernd in Höhe der Leiterplattenseite (43) des Gehäuses (40) die Lötanschlußflächen (44a, 45a) bilden und daß die Stützelemente (48) entsprechend geformt sind, um die Abstützflächen (48a) in der gleichen Höhe zu bilden.

9. Bauelement nach einem der Ansprüche 1 bis **7, dadurch gekennzeichnet,** daß die Anschlußfahnen (54, 55) und die Stützelemente (58) jeweils in Richtung auf die Leiterplattenseite (53) des Gehäuses (50) und über diese hinaus nach unten gekröpft sind, derart, daß Lötanschlußflächen (54a, 55a) und Abstützflächen (58a) in einer Ebene unterhalb der Leiterplattenseite (53) des Gehäuses (50) gebildet sind.

10. Verfahren zum Einbau eines Bauelementes nach einem der Ansprüche 1 bis 9 auf einer Leiterplatte (20), **dadurch gekennzeichnet,** daß das Bauelement (1) mit den Lötanschlußflächen (14a, 15a; 34a, 35a; 44a, 45a; 54a, 55a) der Anschlußfahnen (14, 15; 34, 35; 44, 45; 54, 55) auf Lötpunkten bzw. Leiterbahnen (21) und die Abstützflächen (18a; 38a; 48a; 58a) auf Auflagepunkten (24) der Leiterplatte (20) positioniert werden und daß dann zumindest die Lötanschlußflächen (14a, 15a; 34a, 35a; 44a, 45a; 54a, 55a) mit der Leiterplatte verlötet werden.

11. Verfahren nach Anspruch 10 in Verbindung mit Anspruch 6, **dadurch gekennzeichnet,** daß die aus Metall bestehenden Stützelemente (38a; 48a; 58a) mit metallisierten Auflagepunkten (24) verlötet werden.

12. Verfahren nach Anspruch 10, **dadurch gekennzeichnet,** daß die Stützelemente mit den Auflagepunkten verklebt werden.

13. Verfahren nach einem der Ansprüche 10 bis 12 in Verbindung mit Anspruch 4, **dadurch gekennzeichnet,** daß an den Stützelementen (18) angeformte Haltezapfen (19) in Haltebohrungen (23) der Leiterplatte (20) eingesteckt werden.

14. Verfahren nach Anspruch 13, **dadurch gekennzeichnet,** daß die Haltezapfen (19) in den Haltebohrungen (23) der Leiterplatte form- und/oder kraftschlüssig verankert werden.

15. Verfahren nach einem der Ansprüche 10 bis 14, **dadurch gekennzeichnet,** daß in der Leiterplatte (20) eine Aussparung (22) entsprechend der Umfangskontur des Bauelement-Gehäuses (10) vorgesehen ist, daß das Gehäuse (10) in die Aussparung eingesetzt wird, wobei die Anschlußfahnen (14, 15) einerseits und die Stützelemente (18) andererseits neben der Aussparung auf der Leiterplatte (20) aufliegen, und daß dann die Lötanschlußflächen (14a, 15a) mit den Lötpunkten bzw. Leiterbahnen (21) der Leiterplatte (20) verlötet werden.

## Claims

1. Electrical component, in particular a relay, having an approximately cuboid case (10; 30; 40; 50) which has a connection side (11; 31; 41; 51) from which connecting tabs (14, 15; 34, 35; 44, 45; 54, 55) emerge in a single straight row alongside one another, in which case the connecting tabs form flat solder connection surfaces (14a, 15a; 34a, 35a; 44a, 45a; 54a, 55a) which face one printed circuit board side (13; 33; 43; 53) of the component and lie in a common plane, characterized in that the case (10; 30; 40; 50) has at least one projecting supporting element (18; 38; 48; 58) on at least one further side (16, 17; 36; 46; 56), which supporting element (18; 38; 48; 58) forms a supporting surface (18a; 38a; 48a; 58a) lying in the plane of the solder connection surfaces.

2. Component according to Claim 1, characterized in that supporting elements are provided in the form of projecting arms (18) on two mutually opposite sides (16, 17) of the case (10) which are adjacent to the connection side (11).

3. Component according to Claim 1 or 2, characterized in that supporting elements (38; 48; 58) are provided on the case side (36; 46; 56) which is opposite the connection side (31; 41; 51).

4. Component according to one of Claims 1 to 3, characterized in that the supporting elements (18) have retaining pins (19) which point at right angles to the plane of the supporting surfaces.

5. Component according to Claim 4, characterized in that the retaining pins (19) are provided with latching or clamping elements (19a, 19b).

6. Component according to one of Claims 1 to 5, characterized in that the supporting elements (38; 48; 58) are composed of metal and are anchored, in the form of sheet-metal strips or wires, in the case.

7. Component according to one of Claims 1 to 5, characterized in that the supporting elements (18) are formed integrally with a part of the case composed of plastic.

8. Component according to one of Claims 1 to 7, characterized in that the connecting tabs (44, 45) are bent parallel to one another in the direction of the printed circuit board side (43) and form the solder connection surfaces (44a, 45a) approximately at the level of the printed circuit board side (43) of the case (40), and in that the supporting elements (48) are formed in a corresponding manner, in order to form the supporting surfaces (48a) at the same level.

9. Component according to one of Claims 1 to 7, characterized in that the connecting tabs (54, 55) and the supporting elements (58) are each bent downwards in the direction of the printed circuit board side (53) of the case (50), and beyond this side, in such a manner that solder connection surfaces (54a, 55a) and supporting surfaces (58a) are formed in a plane underneath the printed circuit board side (53) of the case (50).

10. Method for fitting a component according to one of Claims 1 to 9 on a printed circuit board (20), characterized in that the component (1) is positioned with the solder connection surfaces (14a, 15a; 34a, 35a; 44a, 45a; 54a, 55a) of the connecting tabs (14, 15; 34, 35; 44, 45; 54, 55) on solder points or conductor tracks (21), and the supporting surfaces (18a; 38a; 48a; 58a) are positioned on contact points (24) on the printed circuit board (20), and in that at least the solder connection surfaces (14a, 15a; 34a, 35a; 44a, 45a; 54a, 55a) are then soldered to the printed circuit board.

11. Method according to Claim 10 in conjunction with Claim 6, characterized in that the metal supporting elements (38a; 48a; 58a) are soldered to metallized contact points (24).

12. Method according to Claim 10, characterized in that the supporting elements are bonded to the contact points.

13. Method according to one of Claims 10 to 12 in conjunction with Claim 4, characterized in that retaining pins (19) which are integrally formed on the supporting elements (18) are inserted into retaining holes (23) in the printed circuit board (20).

14. Method according to Claim 13, characterized in that the retaining pins (19) are anchored in a positively-locking and/or force-fitting manner in the retaining holes (23) in the printed circuit board.

15. Method according to one of Claims 10 to 14, characterized in that a cut-out (22) corresponding to the contour of the circumference of the component case (10) is provided in the printed circuit board (20), in that the case (10) is inserted into the cut-out, with the connecting tabs (14, 15) resting on the printed circuit board (20) on one side and the supporting elements (18) resting on the printed circuit board (20) on the other side alongside the cut-out, and in that the solder connection surfaces (14a, 15a) are then soldered to the solder points or conductor tracks (21) on the printed circuit board (20).

## Revendications

1. Elément électrique, notamment relais, comprenant un boîtier (10; 30; 40; 50) à peu près parallélépipédique pourvu d'une face de connexion (11; 31; 41; 51) d'où sortent des broches de connexion (14, 15; 34, 35; 44, 45; 54, 55) situées les unes à côté des autres en une seule rangée rectiligne, les broches de connexion formant des surfaces de connexion à souder plates (14a, 15a; 34a, 35a; 44a, 45a; 54a, 55a) situées dans un plan commun et tournées vers une face pour circuit imprimé (13; 33; 43; 53) de l'élément, caractérisé en ce que le boîtier (10; 30; 40; 50) est pourvu, sur au moins un autre côté (16, 17; 36; 46; 56), d'au moins un élément de support (18; 38; 48; 58) saillant qui forme une surface d'appui (18a; 38a; 48a; 58a) située dans le plan des surfaces de connexion à souder.

2. Elément selon la revendication 1, caractérisé en ce que l'on prévoit des éléments de support sous la forme de bras saillants (18) sur deux côtés opposés (16, 17) du boîtier (10) adjacents à la face de connexion (11).

3. Elément selon l'une des revendications 1 ou 2, caractérisé en ce que l'on prévoit des éléments de support (38; 48; 58) sur le côté (36; 46; 56) du boîtier opposé à la face de connexion (31; 41; 51).

4. Elément selon l'une des revendications 1 à 3, caractérisé en ce que les éléments de support (18) sont pourvus de tenons de retenue (19) dirigés perpendiculairement au plan des surfaces d'appui.

5. Elément selon la revendication 4, caractérisé en ce que les tenons de retenue (19) sont pourvus d'éléments d'enclenchement ou de serrage (19a, 19b).

6. Elément selon l'une des revendications 1 à 5, caractérisé en ce que les éléments de support (38; 48; 58) sont en métal et sont fixés dans le boîtier sous forme de rubans en tôle ou de fils.

7. Elément selon l'une des revendications 1 à 5, caractérisé en ce que les éléments de support (18) sont solidaires d'une partie du boîtier en matière plastique.

8. Elément selon l'une des revendications 1 à 7, caractérisé en ce que les broches de connexion (44, 45) sont coudées de manière parallèle les unes aux autres en direction de la face pour circuit imprimé (43) et forment les surfaces de connexion à souder (44a, 45a) à peu près à la hauteur de la face pour circuit imprimé (43) du boîtier (40), et en ce que les éléments de support (48) ont une forme correspondante afin de former les surfaces d'appui (48a) à la même hauteur.

9. Elément selon l'une des revendications 1 à 7, caractérisé en ce que les broches de connexion (54, 55) et les éléments de support (58) sont, à chaque fois, coudés vers le bas en direction de la face pour circuit imprimé (53) du boîtier (50) en dépassant celle-ci, de manière à ce que les surfaces de connexion à souder (54a, 55a) et les surfaces d'appui (58a) soient formées dans un plan situé sous la face pour circuit imprimé (53) du boîtier (50).

10. Procédé de montage d'un élément selon l'une des revendications 1 à 9 sur un circuit imprimé (20), caractérisé en ce que l'élément (1) est positionné, avec les surfaces de connexion à souder (14a, 15a; 34a, 35a; 44a, 45a; 54a, 55a) des broches de connexion (14, 15; 34, 35; 44, 45; 54, 55), sur des points de soudage resp. pistes conductives (21) et les surfaces d'appui (18a; 38a; 48a; 58a) sont positionnées sur des points d'appui (24) du circuit imprimé (20), et en ce que l'on soude au moins les surfaces de connexion à souder (14a, 15a; 34a, 35a; 44a, 45a; 54a, 55a) au circuit imprimé.

11. Procédé selon la revendication 10, en liaison avec la revendication 6, caractérisé en ce que les éléments de support (38a; 48a; 58a) en métal sont soudés avec des points d'appui (24) métallisés.

12. Procédé selon la revendication 10, caractérisé en ce que les éléments de support sont collés avec les points d'appui.

13. Procédé selon l'une des revendications 10 à 12, en liaison avec la revendication 4, caractérisé en ce que des tenons de retenue (19) formés sur les éléments de support (18) sont enfoncés dans des alésages de retenue (23) du circuit imprimé (20).

14. Procédé selon la revendication 13, caractérisé en ce que les tenons de retenue (19) sont fixés dans les alésages de retenue (23) du circuit imprimé par conjugaison de forme et/ou par friction.

15. Procédé selon l'une des revendications 10 à 14, caractérisé en ce que le circuit imprimé (20) est pourvu d'un évidement (22) correspondant au contour de la circonférence du boîtier (10) de l'élément, en ce que le boîtier (10) est inséré dans l'évidement, les broches de connexion (14, 15) d'une part et les éléments de support (18) d'autre part étant appuyés sur le circuit imprimé (20) près de l'évidement, et en ce que les surfaces de connexion à souder (14a, 15a) sont alors soudées avec les points de soudage resp. pistes conductives (21) du circuit imprimé (20).
